(19) Europäisches Patentamt
European Patent Office
Office européen des brevets

(11) EP 2 657 297 A1

(12) **EUROPEAN PATENT APPLICATION**
published in accordance with Art. 153(4) EPC

(43) Date of publication:
**30.10.2013 Bulletin 2013/44**

(21) Application number: **11851643.4**

(22) Date of filing: **13.12.2011**

(51) Int Cl.:
***C08L 63/00*** *(2006.01)* ***C08G 59/20*** *(2006.01)*
***H01L 23/28*** *(2006.01)*

(86) International application number:
**PCT/JP2011/078768**

(87) International publication number:
**WO 2012/086463 (28.06.2012 Gazette 2012/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.12.2010 JP 2010282995**

(71) Applicant: **Daicel Corporation**
**Osaka-shi, Osaka 530-0001 (JP)**

(72) Inventor: **TAKENAKA, Hiroto**
**Ohtake-shi**
**Hiroshima 739-0695 (JP)**

(74) Representative: **Grünecker, Kinkeldey, Stockmair & Schwanhäusser**
**Leopoldstrasse 4**
**80802 München (DE)**

(54) **CURABLE EPOXY RESIN COMPOSITION AND PHOTOSEMICONDUCTOR DEVICE USING SAME**

(57) A curable epoxy resin composition according to the present invention is a curable epoxy resin composition which includes a rubber-particle-dispersed epoxy compound (A) including an alicyclic epoxy compound and, dispersed therein, rubber particles. The curable epoxy resin composition further includes an alumina (B); and an aliphatic polyglycidyl ether (C) having a viscosity of 8000 mPa·s or more at 25°C. The rubber particles include a polymer derived from a (meth)acrylic ester as an essential monomer component, have hydroxyl group and/or carboxyl group on a surface thereof, and have an average particle diameter of 10 nm to 500 nm and a maximum particle diameter of 50 nm to 1000 nm. The curable epoxy resin composition gives a cured product having a refractive index with a difference from the refractive index of the rubber particles of within ±0.03.

EP 2 657 297 A1

## Description

### Technical Field

The present invention relates to a curable epoxy resin composition; and an optical semiconductor device including an optical semiconductor element sealed with the curable epoxy resin composition. The curable epoxy resin composition according to the present invention, when cured, gives a cured product (cured article) which excels in thermal stability, lightfastness, and transparency and exhibits cracking resistance at higher level. The curable epoxy resin composition according to the present invention is resistant to resin leakage from a package upon sealing of an optical semiconductor element.

### Background Art

Light-emitting devices such as optical semiconductor devices are in practical use typically in indoor or outdoor display boards, light sources for image reading, traffic signals, and large-screen display units, in which emitters and surroundings thereof are protected mainly by sealing them with epoxy resins. Typically, aromatic epoxy resins having a bisphenol-A skeleton have been widely used as such sealants (encapsulants).

Recent technical advances allow light emitting diodes (LEDs) to have dramatically higher outputs and to perform light emission with higher outputs. When the aromatic epoxy resins, however, are used for sealing of the light-emitting diodes, their aromatic rings absorb light with such high energy and disadvantageously cause the resins to deteriorate and to turn to yellow (yellowing), which yellowing in turn disadvantageously causes luminance degradation.

Liquid alicyclic epoxy resins having an alicyclic skeleton are known as epoxy resins that have good transparency without yellowing unlike the aromatic epoxy resins, and exhibit satisfactory thermal stability. Such liquid alicyclic epoxy resins are typified by 3, 4-epoxycyclohexylmethyl-3', 4'-epoxycyclohexane carboxylate, an adduct of 3, 4-epoxycyclohexylmethyl-3', 4'-epoxycyclohexane carboxylate with ε-caprolactone, and 1, 2, 8, 9-diepoxylimonene. These alicyclic epoxy resins, however, give cured products which are disadvantageously sensitive to various stresses, are susceptible to cracks (cracking) upon the application of a thermal shock as in temperature cycles (in which heating and cooling are repeated alternately), have poor cracking resistance, and thereby fail to ensure reliability typically of electronic components. As used herein the term "cracking resistance" refers to such a property that no crack occurs even upon application of a thermal shock.

As a possible solution to improve cracking resistance, there is known the use of an epoxy resin composition for the sealing of optical semiconductor devices, which epoxy resin composition contains diglycidyl ether of nucleus-hydrogenated bisphenol-A (see Patent Literature (PTL) 1). The epoxy resin composition, however, gives a cured product which is susceptible to coloration and is disadvantageous in lightfastness and thermal stability. PTL 2 discloses a technique for imparting high toughness to an epoxy resin by dispersing a core-shell polymer in the epoxy resin. This literature, however, neither describes nor suggests the transparency of a cured product derived from the epoxy resin. Independently, there is known a technique of blending a polyether polyol into an epoxy resin, and dispersing particles in the epoxy resin, which particles have a butadiene rubber core structure and a methyl methacrylate resin shell structure (see PTL 3). However, a cured product derived from the resulting epoxy resin is not satisfactory in transparency, because the particles used in the epoxy resin have a butadiene rubber core structure.

In contrast to these techniques, an optical semiconductor sealing resin composition is known as a resin composition capable of giving a cured product which has superior cracking resistance while maintaining thermal stability and transparency at high levels. This resin composition is a composition including a rubber-particle-dispersed epoxy resin containing an alicyclic epoxy resin and, dispersed therein, rubber particles with a specific structure, in which a difference in refractive index between the rubber particles and a cured product derived from the composition is controlled within a specific range (see PTL 4).

### Citation List

### Patent Literature

PTL 1: Japanese Unexamined Patent Application Publication (JP-A) No. H09-255764
PTL 2: JP-A No. 2005-255822
PTL 3: JP-A No. H11-240939
PTL 4: PCT International Publication Number WO2010/013407

## Summary of Invention

### Technical Problem

It was found, however, that the resin composition just mentioned above gives a cured product which fails to exhibit sufficient cracking resistance when used for the sealing of a more bulky optical semiconductor element (e.g., a red light-emitting diode). It was also found that, when the resin composition is used for the sealing of an optical semiconductor element, so-called "resin leakage" occurs to impair workability and quality of the product optical semiconductor device. In the resin leakage, the resin composition leaks from a package (e.g., through a gap between a metal line and a reflector in the package).

Under these circumstances, an object of the present invention is to provide a curable epoxy resin composition which gives a cured product exhibiting more satisfactory cracking resistance while maintaining thermal stability, lightfastness, and transparency at high levels and which is resistant to resin leakage from a package upon sealing.
Another object of the present invention is to provide an optical semiconductor device including an optical semiconductor element sealed with the curable epoxy resin composition.

### Solution to Problem

After intensive investigations to achieve the objects, the present inventor has found that a curable epoxy resin composition including a rubber-particle-dispersed epoxy compound containing an alicyclic epoxy compound and, dispersed therein, rubber particles, when further including alumina and a specific aliphatic polyglycidyl ether as essential components, gives a cured product which has thermal stability, lightfastness, and transparency at high levels and exhibits more satisfactory cracking resistance. The present inventor has also found that the curable epoxy resin composition is resistant to resin leakage from a package upon sealing. The curable epoxy resin composition gives a cured product which exhibits transparency, thermal stability, and cracking resistance at high levels, by employing rubber particles having a specific composition and particle sizes within specific ranges, and by controlling a difference in refractive index between the rubber particles and the cured product derived from the curable epoxy resin composition within a specific range. The present invention has been made based on these findings and further investigations.

Specifically, the present invention provides, in an aspect, a curable epoxy resin composition which includes a rubber-particle-dispersed epoxy compound (A) including an alicyclic epoxy compound and, dispersed therein, rubber particles; in which the curable epoxy resin composition further comprises an alumina (B); and an aliphatic polyglycidyl ether (C) having a viscosity of 8000 mPa·s or more at 25°C; the rubber particles include a polymer derived from a (meth) acrylic ester as an essential monomer component, have hydroxyl group and/or carboxyl group on a surface thereof, and have an average particle diameter of 10 nm to 500 nm and a maximum particle diameter of 50 nm to 1000 nm; and the curable epoxy resin composition gives a cured product having a refractive index with a difference from a refractive index of the rubber particles of within $\pm 0.03$.

The curable epoxy resin composition may further include a curing agent (D) and a curing accelerator (E), or may further include a curing catalyst (F).

The curing agent (D) in the curable epoxy resin composition may be an acid anhydride that is liquid at 25°C.

The curing catalyst (F) in the curable epoxy resin composition may be a cationic-polymerization initiator that generates a cationic species through the application of an ultraviolet ray or heat.

The curable epoxy resin composition may further include a glycidyl ether epoxy compound having no aromatic ring (other than the aliphatic polyglycidyl ether (C)) and/or a polyol compound present as a liquid at 25°C (other than a polyether polyol and the aliphatic polyglycidyl ether (C)).

The aliphatic polyglycidyl ether (C) in the curable epoxy resin composition may be a sorbitol polyglycidyl ether.

The curable epoxy resin composition may be used for the sealing of an optical semiconductor.

The present invention further provides, in another aspect, an optical semiconductor device including an optical semiconductor element sealed with the curable epoxy resin composition.

### Advantageous Effects of Invention

Curable epoxy resin compositions according to embodiments of the present invention have the above configurations and, when cured, give cured products which exhibit more satisfactory cracking resistance while maintaining thermal stability, lightfastness, and transparency at high levels. The curable epoxy resin compositions according to the present invention are resistant to resin leakage from a package upon sealing of an optical semiconductor element and thus contribute to better workability and to better quality of the optical semiconductor device. The curable epoxy resin compositions according to the present invention are therefore advantageously usable in various fields including sealants for electrics/electronics related to optical semiconductors. The curable epoxy resin compositions, particularly when used

as sealants for optical semiconductor elements, give optical semiconductor devices which keep on exhibiting high performance over a long time and serve as long-life optical semiconductor devices with high reliability. Brief Description of Drawings

[Fig. 1] Fig. 1 is a schematic diagram (perspective view) illustrating one embodiment of an optical semiconductor device including an element (optical semiconductor element) sealed with a curable epoxy resin composition according to the present invention.

[Fig. 2] Fig. 2 is a schematic diagram (plan view) illustrating one embodiment of the optical semiconductor device including the element (optical semiconductor element) sealed with the curable epoxy resin composition according to the present invention.

[Fig. 3] Fig. 3 is a schematic diagram (cross-sectional view along the line A-A in Fig. 2) illustrating one embodiment of the optical semiconductor device including the element (optical semiconductor element) sealed with the curable epoxy resin composition according to the present invention.

[Fig. 4] Fig. 4 is a schematic diagram (front view) illustrating one embodiment of the optical semiconductor device including the element (optical semiconductor element) sealed with the curable epoxy resin composition according to the present invention.

Description of Embodiments

[Curable Epoxy Resin Composition]

A curable epoxy resin composition according to an embodiment of the present invention includes a rubber-particle-dispersed epoxy compound (A) including an alicyclic epoxy compound and rubber particles dispersed in the alicyclic epoxy compound. The rubber particles include a polymer derived from a (meth) acrylic ester as an essential monomer component, have hydroxyl group and/or carboxyl group on a surface thereof, and have an average particle diameter of 10 nm to 500 nm and a maximum particle diameter of 50 nm to 1000 nm. The curable epoxy resin composition gives a cured product having a refractive index with a difference from the refractive index of the rubber particles of within $\pm$ 0.03. The curable epoxy resin composition according to the present invention further includes an alumina (B); and an aliphatic polyglycidyl ether (C) having a viscosity of 8000 mPa·s or more at 25°C, in addition to the rubber-particle-dispersed epoxy compound (A).

[Rubber-particle-dispersed Epoxy Compound (A)]

A rubber-particle-dispersed epoxy compound (A) for use in the curable epoxy resin composition according to the present invention is a rubber-particle-dispersed epoxy compound (rubber-particle-dispersed epoxy resin) including an alicyclic epoxy compound and specific rubber particles dispersed in the alicyclic epoxy compound. The rubber particles include a polymer derived from a (meth) acrylic ester as an essential monomer component, have hydroxyl group and/or carboxyl group on a surface thereof as a functional group reactive with the alicyclic epoxy compound, and have an average particle diameter of 10 nm to 500 nm and a maximum particle diameter of 50 nm to 1000 nm. The rubber particles have a refractive index with a difference from that of a cured product derived from the curable epoxy resin composition of within $\pm$0.03.

Rubber Particles

Rubber particles for use in the present invention have a multilayer structure (core-shell structure) including a core having rubber elasticity (elastomeric core); and at least one shell layer covering the core. The rubber particles include a polymer derived from a (meth) acrylic ester as an essential monomer component and have, on their surface, hydroxyl group and/or carboxyl group (either of hydroxyl group and carboxyl group, or both) as a functional group reactive with the alicyclic epoxy compound. A resin composition containing rubber particles having neither hydroxyl group nor carboxyl group on their surface disadvantageously gives a cured product which becomes opaque (clouded) by the action of a thermal shock typically under temperature cycle conditions.

The polymer constituting the elastomeric core is essentially derived from, as a monomer component, a (meth) acrylic ester such as methyl (meth) acrylate, ethyl (meth) acrylate, or butyl (meth) acrylate. Exemplary monomer components, other than the (meth) acrylic ester, which may constitute the polymer include aromatic vinyls such as styrene and $\alpha$-methylstyrene; nitriles such as acrylonitrile and methacrylonitrile; conjugated dienes such as butadiene and isoprene; and olefins such as ethylene, propylene, and isobutene.

Monomer components of the polymer constituting the elastomeric core herein preferably include one or more

components selected from aromatic vinyls, nitriles, and conjugated dienes, in combination with a (meth) acrylic ester. The polymer constituting the core is typified by binary copolymers such as (meth) acrylic ester/aromatic vinyl copolymers and (meth) acrylic ester/conjugated diene copolymers; and ternary copolymers such as (meth) acrylic ester/aromatic vinyl/conjugated diene terpolymers. The polymer constituting the core may include a component such as a silicone (e.g., a polydimethylsiloxane or a polyphenylmethylsiloxane); and/or a polyurethane.

Monomer components constituting the elastomeric core may further include, in addition to the monomer components, one or more reactive crosslinkable monomers each having two or more reactive functional groups per monomer (per molecule). Such reactive crosslinkable monomers correspond typically to divinylbenzene, allyl (meth) acrylate, ethylene glycol di(meth) acrylate, diallyl maleate, triallyl cyanurate, diallyl phthalate, and butylene glycol diacrylate.

The elastomeric core for use herein is particularly preferably a core including a (meth) acrylic ester/aromatic vinyl binary copolymer (of which a butyl acrylate/styrene binary copolymer is more preferred), for easy control of the refractive index of the rubber particles.

The elastomeric core may be produced by a normally employed process such as a process of polymerizing the monomers through emulsion polymerization. In the emulsion polymerization, polymerization may be performed by charging all of the monomers at a time; or by polymerizing part of the monomers, and further polymerizing through addition of the remainder continuously or intermittently. A polymerization process using seed particles may also be employed herein.

The shell layer preferably includes a polymer of a different kind from that of the polymer constituting the core. The shell layer has hydroxyl group and/or carboxyl group as a functional group reactive with the alicyclic epoxy compound. This improves adhesiveness (bonding) at the interface with the alicyclic epoxy compound. The resulting curable epoxy resin composition including rubber particles having the shell layer, when cured, can give a cured product which has superior cracking resistance, is transparent without opacity, and is protected from reduction in glass transition temperature.

Monomer components constituting the shell layer preferably include a (meth) acrylic ester such as methyl (meth) acrylate, ethyl (meth) acrylate, and/or butyl (meth) acrylate, as an essential component. Typically, when the core employs butyl acrylate as the constituent (meth) acrylic ester, the shell layer preferably employs another (meth) acrylic ester than butyl acrylate, such as methyl (meth) acrylate, ethyl (meth) acrylate, or butyl methacrylate. In addition to a (meth) acrylic ester, the shell layer may further include one or more monomer components, which are typified by aromatic vinyls such as styrene and α-methylstyrene; and nitriles such as acrylonitrile and methacrylonitrile. Monomer components constituting the shell layer herein preferably include a (meth) acrylic ester in combination with one or more of the aforementioned monomers and particularly preferably include the (meth) acrylic ester in combination with at least an aromatic vinyl, for easy control of the refractive index of the rubber particles.

The monomer components constituting the shell layer preferably further include one or more monomers corresponding to hydroxyalkyl (meth) acrylates such as 2-hydroxyethyl (meth) acrylate; α, β-unsaturated acids such as (meth) acrylic acid; and α, β-unsaturated acid anhydrides such as maleic anhydride, as a monomer component having hydroxyl group and/or carboxyl group as a functional group reactive with the alicyclic epoxy compound.

The monomer components constituting the shell layer for use herein preferably include a (meth) acrylic ester in combination with one or more monomers selected from the aforementioned monomers. Specifically, the shell layer is preferably one including, for example, a ternary copolymer such as (meth) acrylic ester/aromatic; vinyl/hydroxyalkyl (meth) acrylate or (meth) acrylic ester/aromatic vinyl/α, β-unsaturated acid.

The monomer components constituting the shell layer may further include a reactive crosslinkable monomer in addition to the monomers, as in the core. The reactive crosslinkable monomer has two or more reactive functional groups per monomer (per molecule) and is typified by monomers corresponding to divinylbenzene, allyl (meth) acrylate, ethylene glycol di(meth) acrylate, diallyl maleate, triallyl cyanurate, diallyl phthalate, and butylene glycol diacrylate.

Exemplary techniques to cover a core with a shell layer include a technique of applying a copolymer for constituting the shell layer to a surface of an elastomeric core prepared by the above process to cover the core with the shell layer; and a technique of performing graft polymerization of an elastomeric core obtained by the process as a backbone component, and respective components for constituting the shell layer as side-chain components.

The rubber particles in the rubber-particle-dispersed epoxy compound (A) may have an average particle diameter of 10 to 500 nm, and preferably 20 to 400 nm. The rubber particles may have a maximum particle diameter of 50 to 1000 nm, and preferably 100 to 800 nm. Rubber particles, if having an average particle diameter of more than 500 nm or if having a maximum particle diameter of more than 1000 nm, may be liable to cause the cured product to have insufficient transparency and to cause the optical semiconductor device to have a lower luminous intensity. In contrast, rubber particles, if having an average particle diameter of less than 10 nm or if having a maximum particle diameter of less than 50 nm, may cause the cured product to have insufficient cracking resistance.

Though not critical, the rubber particles have a refractive index of preferably 1.40 to 1.60, and more preferably 1.42 to 1.58. The curable epoxy resin composition including the rubber particles (the curable epoxy resin composition according to the present invention) gives a cured product having a refractive index with a difference from the refractive

index of the rubber particles of within ±0.03. If the difference in refractive index exceeds ±0.03, the cured product may have inferior transparency and, in some cases, may become opaque, to cause the optical semiconductor device to have a lower luminous intensity and, at worst, to lose its functions.

The refractive index of the rubber particles can be determined typically by casting 1 gram of the rubber particles into a die; compression-molding the rubber particles at 210°C, at 4 MPa to give a flat plate 1 mm thick; cutting a test piece 20 mm long and 6 mm wide from the flat plate; and measuring a refractive index of the test piece at the sodium D line at 20°C using a multi-wavelength Abbe refractometer (trade name "DR-M2" supplied by ATAGO Co., Ltd.) while keeping a prism and the test piece in intimate contact with each other using monobromonaphthalene as a contact liquid.

The refractive index of a cured product derived from the curable epoxy resin composition according to the present invention can be determined typically by preparing a cured product by the thermal curing process described in the description about the optical semiconductor device below: cutting a test piece 20 mm long, 6 mm wide, and 1 mm thick from the cured product; and measuring a refractive index of the test piece at the sodium D line at 20°C using a multi-wavelength Abbe refractometer (trade name "DR-M2" supplied by ATAGO Co., Ltd.) while keeping a prism and the test piece in intimate contact with each other using monobromonaphthalene as a contact liquid.

Alicyclic Epoxy Compound

An alicyclic epoxy compound (alicyclic epoxy resin) constituting the rubber-particle-dispersed epoxy compound (A) for use herein is an alicyclic compound having an epoxy group including oxygen atom and adjacent two carbon atoms constituting an aliphatic ring and can be arbitrarily chosen from among known or customary ones. The alicyclic epoxy compound is preferably one present as a liquid at room temperature (25°C), for good workability upon preparation (blending) and casting.

Among such compounds, the alicyclic epoxy compound for use herein is preferably an alicyclic epoxy compound represented by following Formula (1), for satisfactory transparency and thermal stability.

[Chem. 1]

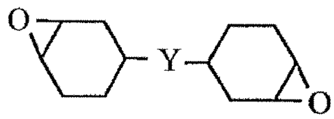

(1)

In Formula (1), Y represents single bond or a linkage group. The linkage group is typified by divalent hydrocarbon groups, carbonyl group (-CO-), ether bond (-O-), ester bond (-COO-), amide bond (-CONH-), carbonate bond (-OCOO-), and groups each including two or more of them bonded to each other.

The divalent hydrocarbon groups are typified by linear or branched chain alkylene groups having 1 to 18 carbon atoms; and divalent alicyclic hydrocarbon groups. The linear or branched chain alkylene groups are exemplified by methylene, methylmethylene, dimethylmethylene, ethylene, propylene, and trimethylene groups. The divalent alicyclic hydrocarbon groups are exemplified by divalent cycloalkylene groups (including cycloalkylidene groups), such as 1, 2-cyclopentylene, 1, 3-cyclopentylene, cyclopentylidene, 1, 2-cyclohexylene, 1, 3-cyclohexylene, 1, 4-cyclohexylene, and cyclohexylidene groups.

Typical examples of the alicyclic epoxy compound represented by Formula (1) include compounds represented by following Formulae (1a) to (1j). In the following formulae, each of n1 to n8 independently represents an integer of 1 to 30. In Formula (1e), -O-R-O- represents a diol residue. R is typified by divalent hydrocarbon groups; and divalent groups each including two or more divalent hydrocarbon groups bonded to each other through one or more linkage groups such as ether bonds, ester bonds, amide bonds, and carbonyl groups. The divalent hydrocarbon groups are typified by groups as with the divalent hydrocarbon groups as Y.

[Chem. 2]

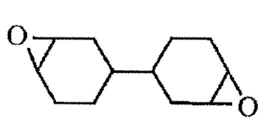

(1a)

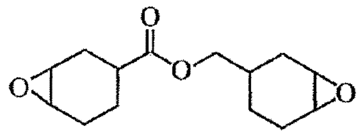

(1b)

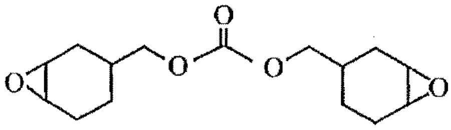

(1c)

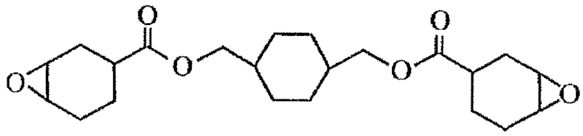

(1d)

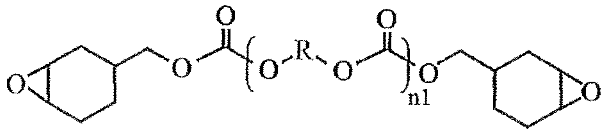

(1e)

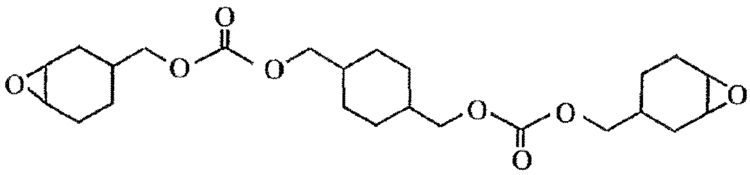

(1f)

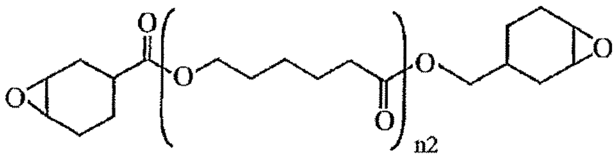

(1g)

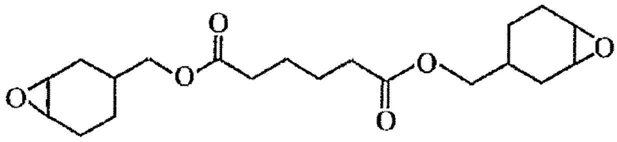

(1h)

[Chem. 3]

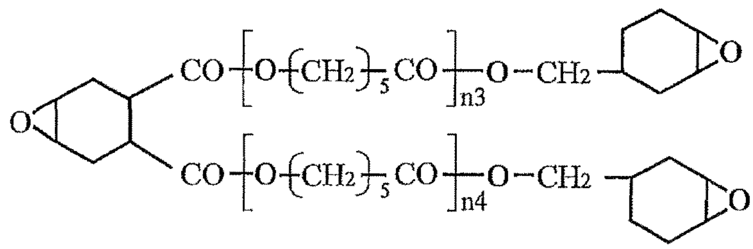

(1i)

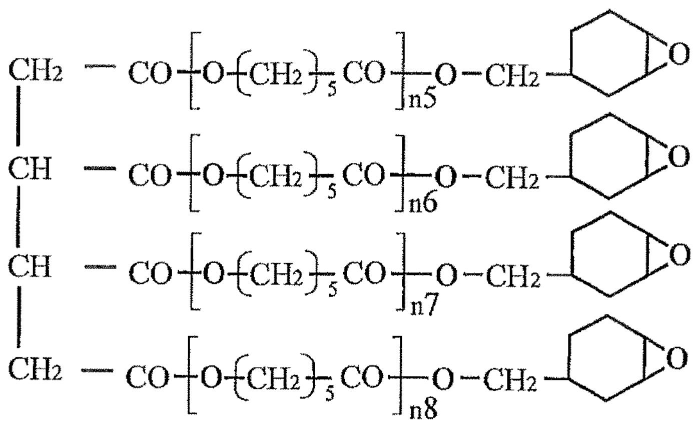

(1j)

Each of different alicyclic epoxy compounds may be used alone or in combination. Alicyclic epoxy compounds may also be available as commercial products typically under the trade names "CELLOXIDE 2021P" and "CELLOXIDE 2081" (each supplied by Daicel Chemical Industries Ltd.).

The rubber-particle-dispersed epoxy compound (A) for use herein includes the rubber particles dispersed in the alicyclic epoxy compound. The rubber-particle-dispersed epoxy compound (A) may include the rubber particles in an amount of preferably 0.5 to 30 percent by weight, and more preferably 1 to 20 percent by weight, based on the total amount (100 percent by weight) of the rubber-particle-dispersed epoxy compound (A), though the amount is suitably controllable according to necessity and is not critical. A rubber-particle-dispersed epoxy compound (A) including the rubber particles in an amount of less than 0.5 percent by weight may adversely affect the cracking resistance. In contrast, a rubber-particle-dispersed epoxy compound (A) including the rubber particles in an amount of more than 30 percent by weight may tend to adversely affect the thermal stability and transparency.

Though not critical, the rubber-particle-dispersed epoxy compound (A) has a viscosity at 25°C (viscosity (25°C)) of preferably 400 mPa·s to 50000 mPa·s, and particularly preferably 500 mPa·s to 10000 mPa·s. A rubber-particle-dispersed epoxy compound (A) having a viscosity (25°C) of less than 400 mPa·s may adversely affect the transparency. In contrast, a rubber-particle-dispersed epoxy compound (A) having a viscosity (25°C) of more than 50000 mPa·s may often adversely affect productivity both in production of the rubber-particle-dispersed epoxy compound (A) and in production of the curable epoxy resin composition.

The viscosity of the rubber-particle-dispersed epoxy compound (A) may be controllable by the use of a reactive diluent. The reactive diluent is preferably an aliphatic polyglycidyl ether having a viscosity at room temperature (25°C) of 200 mPa·s or less. The aliphatic polyglycidyl ether having a viscosity (25°C) of 200 mPa·s or less is typified by cyclohexanedimethanol diglycidyl ether, cyclohexanediol diglycidyl ether, neopentyl glycol diglycidyl ether, 1, 6-hexanediol diglycidyl ether, trimethylolpropane triglycidyl ether, and polypropylene glycol diglycidyl ethers.

The reactive diluent may be used in an amount of preferably 30 parts by weight or less, and more preferably 25 parts by weight or less (e.g., 5 to 25 parts by weight), per 100 parts by weight of the rubber-particle-dispersed epoxy

compound (A), though the amount may be suitably adjusted and is not critical. A reactive diluent used in an amount of more than 30 parts by weight may tend to prevent the cured product from having desired properties such as cracking resistance.

The rubber-particle-dispersed epoxy compound (A) for use herein may be produced by any process being not critical and chosen from among known or customary processes, such as a process of desiccating (dewatering) and drying rubber particles to give a powder, and mixing the powder with an alicyclic epoxy compound to disperse the powder therein; and a process of directly mixing an emulsion of rubber particles with an alicyclic epoxy compound to give a mixture, and desiccating the mixture.

Though not critical, the curable epoxy resin composition may employ (include) the rubber-particle-dispersed epoxy compound (A) in an amount of preferably 30 to 90 percent by weight, and particularly preferably 50 to 90 percent by weight, based on the total amount (100 percent by weight) of entire epoxy-containing resins (entire epoxy-containing compounds) contained in the curable epoxy resin composition. A curable epoxy resin composition containing the rubber-particle-dispersed epoxy compound (A) in an amount of less than 30 percent by weight may tend to give a cured product having insufficient cracking resistance.

[Alumina (B)]

An alumina (B) for use in the curable epoxy resin composition according to the present invention has the functions of preventing resin leakage from a package upon sealing and improving cracking resistance of the cured product. The alumina (B) is not limited and may be known or customary alumina (aluminum oxide) particles. Each of different aluminas (B) may be used alone or in combination.

The alumina (B) may have any shape not critical, such as spheroid, crushed, fibrous, needle-like, scale-like, or whisker shape. Among such shapes, the alumina (B) preferably has a spheroid shape, and more preferably has a spherical shape, for satisfactory dispersibility of the alumina particles.

Though not critical, the alumina (B) has an average particle diameter (average particle size) of preferably 0.1 to 20 μm, and more preferably 0.1 to 10 μm, for good transparency. As used herein the term "average particle diameter" refers to a particle size at which a cumulative distribution percentage reaches 50% in a particle size distribution measured by the laser diffraction/scattering technique.

The alumina (B) may be one prepared by a known or customary preparation process. Exemplary preparation processes for the alumina (B) include dry processes such as gas-phase oxidation; and wet processes such as hydrothermal synthesis. Among them, vaporized metal combustion (VMC; see, for example, JP-A No. 2008-174624) process is preferred. Specifically, the alumina (B) for use in the curable epoxy resin composition according to the present invention is preferably an alumina prepared by VMC process.

The alumina (B) may also be any of commercial products typically under the trade name "AO-802" (supplied by Admatechs Company Limited, average particle size: 0.7 μm, shape: spherical, preparation process: VMC process) and the trade name "AO-502" (supplied by Admatechs Company Limited, average particle size: 0.7 μm, shape: spherical, preparation process: VMC process).

Though not critical, the curable epoxy resin composition may employ (include) the alumina (B) in an amount of preferably 0.1 to 3 parts by weight, and more preferably 0.1 to 1 parts by weight, per 100 parts by weight of entire epoxy-containing resins contained in the curable epoxy resin composition. A curable epoxy resin composition containing the alumina (B) in an amount of more than 3 parts by weight may give a cured product having insufficient transparency. In contrast, a curable epoxy resin composition containing the alumina (B) in an amount of less than 0.1 part by weight may often suffer from resin leakage from a package or may give a cured product having insufficient cracking resistance.

[Aliphatic Polyglycidyl Ether (C)]

An aliphatic polyglycidyl ether (C) for use in the curable epoxy resin composition according to the present invention has the function of improving the cracking resistance of the cured product. The aliphatic polyglycidyl ether (C) for use herein is a compound corresponding to an aliphatic polyol, except with part or all of hydroxyl groups being glycidyl-etherified. As used herein the term "aliphatic polyol" refers to a compound corresponding to a chain (straight or branched chain) hydrocarbon, except with two or more hydrogen atoms being substituted with hydroxyl groups (alcoholic hydroxyl groups). The aliphatic polyol is typified by, but is not limited to, sorbitol. Each of different aliphatic glycidyl ethers (C) may be used alone or in combination.

The aliphatic polyglycidyl ether (C) is an aliphatic polyglycidyl ether having a viscosity of 8000 mPa·s or more at 25°C. The aliphatic polyglycidyl ether (C) has a viscosity of typically preferably 8000 to 20000 mPa·s at 25°C. An aliphatic polyglycidyl ether having a viscosity of less than 8000 mPa·s at 25°C, if employed instead of the aliphatic polyglycidyl ether (C), may adversely affect the cracking resistance. The viscosity of the aliphatic glycidyl ether (C) at 25°C may be measured using a digital viscometer (trade name "Model DVU-EII" supplied by Tokimec, Inc.) with a

standard rotor 1°34'xR24 as a rotor at a temperature of 25°C and a number of revolutions of 0.5 to 10 rpm.

The aliphatic polyglycidyl ether (C) is not limited, as long as being an aliphatic polyglycidyl ether having a viscosity (25°C) of 8000 mPa·s or more, but is typified by sorbitol polyglycidyl ethers, xylitol polyglycidyl ethers, and mannitol polyglycidyl ethers. Among them, sorbitol polyglycidyl ethers are preferred from the viewpoint of cracking resistance.

Though not critical, the aliphatic polyglycidyl ether (C) (particularly sorbitol polyglycidyl ether) has epoxy groups preferably in an average number per molecule (average number of epoxy groups) of 3 to 4 for better cracking resistance.

Though not critical, the aliphatic polyglycidyl ether (C) (particularly sorbitol polyglycidyl ether) has hydroxyl groups preferably in an average number per molecule (average number of hydroxyl groups) of 1 to 2 for better cracking resistance.

The aliphatic polyglycidyl ether (C) may also be any of commercial products typically under the trade name "ERISYS GE60" (supplied by CVC Thermoset Specialties, having a viscosity (25°C) of 13000 mPa·s and an average number of epoxy groups of about 4).

The aliphatic polyglycidyl ether (C) may be prepared by a known or customary preparation process. Typically, the aliphatic polyglycidyl ether (C) may be prepared by allowing epichlorohydrin to react with the aliphatic polyol (e.g., sorbitol).

Though not critical, the curable epoxy resin composition according to the present invention may employ (include) the aliphatic polyglycidyl ether (C) in an amount of preferably 10 to 30 percent by weight, and more preferably 10 to 20 percent by weight, relative to the total amount (100 percent by weight) of entire epoxy-containing resins contained in the curable epoxy resin composition. A curable epoxy resin composition containing the aliphatic polyglycidyl ether (C) in an amount of less than 10 percent by weight may give a cured product with insufficient cracking resistance.

The curable epoxy resin composition according to the present invention includes at least the rubber-particle-dispersed epoxy compound (A), the alumina (B), and the aliphatic polyglycidyl ether (C). Preferred exemplary embodiments of the curable epoxy resin composition according to the present invention include an embodiment in which the curable epoxy resin composition includes five components, i.e., the rubber-particle-dispersed epoxy compound (A), the alumina (B), the aliphatic polyglycidyl ether (C), a curing agent (D), and a curing accelerator (E) as essential components; and an embodiment in which the curable epoxy resin composition includes four components, i.e., the rubber-particle-dispersed epoxy compound (A), the alumina (B), the aliphatic polyglycidyl ether (C), and a curing catalyst (F) as essential components.

[Curing Agent (D)]

A curing agent (D) has the function of curing an epoxy-containing compound. The curing agent (D) may be any of known or customary curing agents serving as epoxy resin curing agents. Among them, the curing agent (D) is preferably an acid anhydride that is liquid at 25°C, which is typified by methyltetrahydrophthalic anhydride, methylhexahydrophthalic anhydride, dodecenylsuccinic anhydride, and methyl-endomethylene-tetrahydrophthalic anhydride. Even an acid anhydride being solid at room temperature (25°C) (e.g., phthalic anhydride, tetrahydrophthalic anhydride, hexahydrophthalic anhydride, or methylcyclohexenedicarboxylic anhydride) may be used as the curing agent (D), as a liquid mixture prepared by dissolving the same in an acid anhydride being liquid at room temperature (25°C). Each of different curing agents (D) may be used alone or in combination.

The curing agent (D) for use herein may also be any of commercial products typically under the trade name "Rikacid MH-700" (supplied by New Japan Chemical Co., Ltd.) and the trade name "HN-5500" (supplied by Hitachi Chemical Co., Ltd.).

The curing agent (D) may be used in an amount not critical but preferably 50 to 150 parts by weight, more preferably 52 to 145 parts by weight, and furthermore preferably 55 to 140 parts by weight, per 100 parts by weight of entire epoxy-containing resins contained in the curable epoxy resin composition. More specifically, the curing agent (D) is preferably used in an amount of 0.5 to 1.5 equivalents per 1 equivalent of epoxy group of entire epoxy-containing compounds contained in the curable epoxy resin composition. A curing agent (D) used in an amount of less than 50 parts by weight may tend to cause insufficient curing and to cause the cured product to have insufficient toughness. In contrast, a curing agent (D) used in an amount of more than 150 parts by weight may cause the cured product to be colored and to have inferior hue.

[Curing Accelerator (E)]

The curing accelerator (E) is a compound having the function of accelerating (increasing) the curing rate upon curing of an epoxy-containing compound by the action of the curing agent (D). The curing accelerator (E) is not critical, can be any of known or customary curing accelerators, but is typified by 1, 8-diazabicyclo [5.4.0] undecene-7 (DBU), and salts thereof (e.g., phenol salt, octylic acid salt, p-toluenesulfonic acid salt, formic acid salt, and tetraphenylborate

salt); 1, 5-diazabicyclo [4.3.0] nonene-5 (DBN), and salts thereof (e.g., phosphonium salt, sulfonium salt, quaternary ammonium salt, and iodonium salt); tertiary amines such as benzyldimethylamine, 2, 4, 6-tris(dimethylaminomethyl) phenol, and N, N-dimethylcyclohexylamine; imidazoles such as 2-ethyl-4-methylimidazole and 1-cyanoethyl-2-ethyl-4-methylimidazole; phosphoric esters; phosphines such as triphenylphosphine; phosphonium compounds such as tetraphenylphosphonium tetra(p-tolyl) borate; organic metal salts such as tin octylate and zinc octylate; and metal chelates. Each of them may be used alone or in combination.

The curing accelerator (E) for use herein may also be any of commercial products such as products under the trade names "U-CAT SA 506", "U-CAT SA 102", "U-CAT 5003", "U-CAT 18X", and "12XD (product under development) " (each supplied by San-Apro Ltd..); the trade names "TPP-K" and "TPP-MK" (each supplied by Hokko Chemical Industry Co., Ltd.), and the trade name "PX--4ET" (supplied by Nippon Chemical Industrial Co., Ltd.).

Though not critical, the curing accelerator (E) may be used in an amount of preferably 0.05 to 5 parts by weight, more preferably 0.1 to 3 parts by weight, furthermore preferably 0.2 to 3 parts by weight, and particularly preferably 0.25 to 2.5 parts by weight, per 100 parts by weight of entire epoxy-containing resins contained in the curable epoxy resin composition. The curing accelerator (E), if used in an amount of less than 0.05 part by weight, may not sufficiently effectively accelerate curing. In contrast, the curing accelerator (E), if used in an amount of more than 5 parts by weight, may cause the cured product to be colored and to have inferior hue.

[Curing Catalyst (F)]

The curing catalyst (F) for use herein has the function of initiating polymerization of epoxy compounds in the curable epoxy resin composition. The curing catalyst (F) is preferably a cationic-polymerization initiator that generates a cationic species by the application of an ultraviolet ray or heat to initiate polymerization of the rubber-particle-dispersed epoxy compound (A). Each of different curing catalysts (F) may be used alone or in combination.

Exemplary cationic-polymerization initiators that generate a cationic species upon the application of an ultraviolet ray include hexafluoroantimonate salts, pentafluorohydroxyantimonate salts, hexafluorophosphate salts, and hexafluoroarsenate salts. Such cationic-polymerization initiators are preferably available as commercial products such as products under the trade name "UVACURE 1590" (supplied by Daicel-Cytec Co., Ltd..); the trade names "CD-1010", "CD-1011", and "CD-1012" (each supplied by Sartomer Company Inc., USA); the trade name "IRGACURE 264" (supplied by Ciba Japan), and the trade name "CIT-1682" (supplied by Nippon Soda Co., Ltd.).

Exemplary cationic-polymerization initiators that generate a cationic species by the application of heat (heating treatment) include aryldiazonium salts, aryliodonium salts, arylsulfonium salts, and allene-ion complexes. Such cationic-polymerization initiators are preferably available as commercial products such as products under the trade names "PP-33", "CP-66", and "CP-77" (each supplied by ADEKA CORPORATION); the trade name "FC-509" (supplied by 3M Company); the trade name "UVE1014" (supplied by General Electric Company); the trade name "San-Aid SI-60L", "San-Aid SI-80L", "San-Aid SI-100L", "San-Aid SI-110L", and "San-Aid SI-150L" (each supplied by Sanshin Chemical Industry Co., Ltd.), and the trade name "CG-24-61" (supplied by Ciba Japan). Examples of the cationic-polymerization initiator usable herein further include compounds between a chelate compound and a silanol (e.g., triphenylsilanol), which chelate compound is formed between a metal (e.g., aluminum or titanium) and acetoacetic acid or a diketone; and compounds between a chelate compound and a phenol (e.g., bisphenol-S), which chelate compound is formed between a metal (e.g., aluminum or titanium) and acetoacetic acid or a diketone.

Though not critical, the curing catalyst (F) may be used in an amount of preferably 0.01 to 15 parts by weight, more preferably 0.01 to 12 parts by weight, furthermore preferably 0.05 to 10 parts by weight, and particularly preferably 0.1 to 10 parts by weight, per 100 parts by weight of entire epoxy-containing resins contained in the curable epoxy resin composition. The curing catalyst (F), when used in an amount within the above-specified range, may give a cured product which excels in thermal stability, transparency, and lightfastness.

The curable epoxy resin composition according to the present invention may further include an alicyclic epoxy compound containing no rubber particle, in addition to the curing agent (D) and the curing accelerator (E), or in addition to the curing catalyst (F). The alicyclic epoxy compound is typified by the alicyclic epoxy compounds represented by Formula (1). The alicyclic epoxy compound containing no rubber particle may be used (contained) in an amount of preferably less than 70 percent by weight, and more preferably less than 50 percent by weight, based on the total amount (100 percent by weight) of entire epoxy-containing resins contained in the curable epoxy resin composition. An alicyclic epoxy compound containing no rubber particle used in an amount of more than 70 percent by weight of entire epoxy-containing resins may tend to cause the resulting cured product to have insufficient cracking resistance.

The curable epoxy resin composition according to the present invention may further contain one or more of other components including glycidyl ether epoxy compounds having an aromatic ring, such as bisphenol-A and bisphenol-F glycidyl ether epoxy compounds; glycidyl ether epoxy compounds having no aromatic ring (except the aliphatic polyglycidyl ethers (C)), such as hydrogenated bisphenol-A glycidyl ether epoxy compounds and aliphatic glycidyl ether epoxy compounds; glycidyl ester epoxy compounds; glycidylamine epoxy compounds; polyol compounds; oxetane

compounds; and vinyl ether compounds.

The curable epoxy resin composition may further include even an epoxy compound being solid at room temperature (25°C), as long as being present as a liquid after blending. The epoxy compound being solid at room temperature (25°C) is typified by solid bisphenol epoxy compounds, novolak epoxy compounds, glycidyl esters, triglycidyl isocyanurate, an adduct of 2, 2-bis(hydroxymethyl) -1-butanol with 1, 2-epoxy-4-(2-oxiranyl) cyclohexane (trade name "EHPE3150" supplied by Daicel Chemical Industries Ltd.). Each of different epoxy compounds may be used alone or in combination.

Among them, the curable epoxy resin composition according to the present invention preferably further includes a glycidyl ether epoxy compound having no aromatic ring (except the aliphatic polyglycidyl ethers (C)) and/or a polyol compound present as a liquid at 25°C (except polyether polyols and the aliphatic polyglycidyl ethers (C)), in addition to the curing agent (D) and the curing accelerator (E), or in addition to the curing catalyst (F). This configuration is preferred for better cracking resistance without impairing satisfactory thermal stability. Above all, the curable epoxy resin composition particularly preferably further include a glycidyl ether epoxy compound having no aromatic ring for better cracking resistance without impairing satisfactory thermal stability and lightfastness.

[Glycidyl Ether Epoxy Compound Having No Aromatic Ring]

Exemplary glycidyl ether epoxy compounds having no aromatic ring for use herein include aliphatic glycidyl ether epoxy compounds; and nucleus-hydrogenated compounds corresponding to aromatic glycidyl ether epoxy compounds. The term "glycidyl ether epoxy compound having no aromatic ring" as used herein does not include the aliphatic polyglycidyl ethers (C). Preferred examples of the glycidyl ether epoxy compound having no aromatic ring include commercial products such as products under the trade names "EPICLON 703", "EPICLON 707", "EPICLON 720", and "EPICLON 725" (each supplied by DIC Corporation); the trade names "YH-300", "YH-315", "YH-324-, "PG-202", "PG-207", and "SUNTOHTO ST-3000" (each supplied by Tohto Kasei Co., Ltd.); the trade names "Rikaresin DME-100" and "Rikaresin HBE-100" (each supplied by New Japan Chemical Co., Ltd.); the trade names "Denacol EX-212" and "Denacol EX-321" (each supplied by Nagase ChemteX Corporation); and the trade names "YX8000" and "YX8034" (each supplied by Japan Epoxy Resins Co., Ltd.). Each of different glycidyl ether epoxy compounds having no aromatic rings may be used alone or in combination.

Though not critical, the glycidyl ether epoxy compound having no aromatic ring may be used in an amount of preferably 10 to 50 parts by weight, and more preferably 10 to 30 parts by weight, per 100 parts by weight of alicyclic epoxy compounds.

[Polyol Compound Present as a Liquid at 25°C]

Exemplary polyol compounds present as a liquid at 25°C include polyol compounds other than polyether polyols and are typified by polyester polyols and polycarbonate polyols. The "polyol compound present as a liquid at 25°C" herein does not include the aliphatic polyglycidyl ethers (C). Each of different polyol compounds present as a liquid at 25°C may be used alone or in combination.

Such polyester polyols usable herein are typified by commercial products such as products under the trade names "PLACCEL 205", "PLACCEL 205H", "PLACCEL 205U", "PLACCEL 205BA", "PLACCEL 208", "PLACCEL 210", "PLACCEL 210CP", "PLACCEL 210BA", "PLACCEL 212", "PLACCEL 212CP", "PLACCEL 220", "PLACCEL 220CPB", "PLACCEL 220NP1", "PLACCEL 220BA", "PLACCEL 220ED", "PLACCEL 220EB", "PLACCEL 220EC", "PLACCEL 230", "PLACCEL 230CP", "PLACCEL 240", "PLACCEL 240CP", "PLACCEL 210N", "PLACCEL 220N", "PLACCEL L205AL", "PLACCEL L208AL", "PLACCEL L212AL", "PLACCEL L220AL", "PLACCEL L230AL", "PLACCEL 305", "PLACCEL 308", "PLACCEL 312", "PLACCEL L312AL", "PLACCEL 320", "PLACCEL L320AL", "PLACCEL L330AL", "PLACCEL 410", "PLACCEL 410D", "PLACCEL 610", "PLACCEL P3403", and "PLACCEL CDE9P" (each supplied by Daicel Chemical Industries Ltd.).

Polycarbonate polyols usable herein are typified by commercial products available typically under the trade names "PLACCEL CD205PL", "PLACCEL CD205HL", "PLACCEL CD210PL", "PLACCEL CD210HL", "PLACCEL CD220PL", and "PLACCEL CD220HL" (each supplied by Daicel Chemical Industries Ltd.); the trade names "UH-CARB50", "UH-CARB100", "UH-CARB300", "UH-CARB90(1/3) ", "UH-CARB90(1/1) ", and "UC-CARB100" (each supplied by Ube Industries, Ltd.); and the trade names "PCDL T4671", "PCDL T4672", "PCDL T5650J", "PCDL T5651", and "PCDL T5652" (each supplied by Asahi Kasei Chemicals Corporation).

Though not critical, the polyol compound present as a liquid at 25°C may be used in an amount of preferably 5 to 50 parts by weight, and more preferably 10 to 40 parts by weight, per 100 parts by weight of the rubber-particle-dispersed epoxy compound (A).

In addition to the above components, the curable epoxy resin composition according to the present invention may further employ any of additives within ranges not adversely affecting advantageous effects of the present invention.

A hydroxyl-containing compound, when employed as an additive, may allow the reaction to proceed mildly. The hydroxyl-containing compound is typified by ethylene glycol, diethylene glycol, propylene glycol, and glycerol. In addition or alternatively, the curable epoxy resin composition may employ any of customary additives within ranges not adversely affecting the viscosity and transparency. Such additives are typified by silicone- or fluorine-containing antifoaming agents; leveling agents; silane coupling agents such as γ-glycidoxypropyltrimethoxysilane; surfactants; fillers; flame retardants; colorants; antioxidants; ultraviolet absorbers; ion adsorbents; pigments; and releasing agents. Additives may be used preferably in an amount of 5 percent by weight or less based on the total amount (100 percent by weight) of the curable epoxy resin composition.

The curable epoxy resin composition according to the present invention is prepared by a process not limited and may be prepared by a known or customary process. Specifically, the curable epoxy resin composition may be prepared typically by blending a rubber-particle-dispersed epoxy compound (A), an alumina (B), an aliphatic polyglycidyl ether (C), a curing agent (D), a curing accelerator (E), and optional additives in predetermined amounts, or blending a rubber-particle-dispersed epoxy compound (A), an alumina (B), an aliphatic polyglycidyl ether (C), a curing catalyst (F), and arbitrary additives in predetermined amounts, and string and mixing them with a device such as a mixer (e.g., a dissolver or a homogenizer), a kneader, a roll, a bead mill, or a planetary stirring apparatus. The mixture after stirring and mixing may be subjected to degassing (debubbling) in a vacuum.

The curable epoxy resin composition according to the present invention may be cured into a cured product through the application of heat and/or light such as an ultraviolet ray. The cured product cured from the curable epoxy resin composition according to the present invention can exhibit more satisfactory cracking resistance while maintaining thermal stability, lightfastness, and transparency at high levels. The curable epoxy resin composition according to the present invention is advantageously usable for the sealing typically of optical semiconductors, for the bonding of electronic components, or as liquid crystal panel sheets and sealers. Among them, the curable epoxy resin composition is particularly advantageously usable as a resin composition for the sealing of optical semiconductors.

[Optical Semiconductor Device]

An optical semiconductor device according to an embodiment of the present invention includes an optical semiconductor element sealed with a curable epoxy resin composition for the sealing of an optical semiconductor element according to the present invention. A way to seal the optical semiconductor element is not limited, may be a known or customary technique, and is typified by potting, casting, and printing.

Typically, when potting is employed, an optical semiconductor device including an optical semiconductor element sealed with the curable epoxy resin composition according to the present invention is obtained by pouring the curable epoxy resin composition into a predetermined forming die, and curing the resin composition by heating. The heating and curing may be performed at a heating temperature of 80°C to 200°C, preferably 80°C to 190°C, and furthermore preferably 80°C to 180°C, for a heating time of 30 to 600 minutes, preferably 45 to 540 minutes, and furthermore preferably 60 to 480 minutes. The heating and curing conditions may be suitably adjusted within this range. Typically, the heating time is preferably shortened when heating is performed at a high temperature, and the heating time is preferably prolonged when heating is performed at a low temperature. If the heating temperature and heating time are below the above-specified range, curing may tend to proceed insufficiently. In contrast, if the heating temperature and heating time are above the range, decomposition of resin components may occur. The heating and curing treatment may be performed in one step, or may be performed in multiple steps in which multiple heating treatments are performed to proceed curing stepwise.

In the present invention, curing is preferably performed stepwise by performing heating treatments in multiple steps. This prevents foaming (blister) due to an abrupt curing reaction, relieves stress/strain caused by curing, and thereby improves cracking resistance of the cured product. When a curing agent (D) is used, curing is preferably performed by heating in a first step at a temperature of 80°C to 150°C (preferably 100°C to 140°C) for a duration of 30 to 300 minutes (preferably 45 to 270 minutes) and thereafter heating in a second step at a temperature of 100°C to 200°C (preferably 110°C to 180°C) for a duration of 30 to 600 minutes (preferably 45 to 540 minutes). When a curing catalyst (F) is used, curing is preferably performed by heating in a first step at a temperature of 30°C to 150°C (preferably 40°C to 140°C) for a duration of 30 to 300 minutes (preferably 45 to 270 minutes) and thereafter heating in a second step at a temperature of 60°C to 200°C (preferably 80°C to 180°C) for a duration of 30 to 600 minutes.

The optical semiconductor device according to the present invention includes an optical semiconductor element sealed with the curable epoxy resin composition according to the present invention and can maintain a superior luminous intensity over a long time. The optical semiconductor device can therefore keep on exhibiting high performance over a long time and serves as a long-life optical semiconductor device with high reliability.

EXAMPLES

The present invention will be illustrated in further detail with reference to several working examples below, which are by no means intended to limit the scope of the invention.

The average particle diameter and maximum particle diameter of rubber particles were measured in the following manner. A specimen as mentioned below was subjected to a measurement using the Nanotrac Particle Size Analyzer (trade name "UPA-EX150" supplied by Nikkiso Co., Ltd.) of the "Nanotrac™" system employing dynamic light scattering as a measurement principle, to plot a particle size distribution curve; in the particle size distribution curve, a cumulative average diameter, which is the particle diameter at which the cumulative curve reaches 50%, was defined as the average particle diameter, and a maximum (largest) particle diameter at which the frequency (%) of the measured particle size distribution exceeds 0.00% is defined as the maximum particle diameter.

Specimen:

The specimen was prepared by dispersing 1 part by weight of a rubber-particle-dispersed epoxy compound (A) in 20 parts by weight of tetrahydrofuran.

The refractive index of rubber particles was determined by casting 1 g of the rubber particles into a die; compression-molding the rubber particles at 210°C, 4 MPa to give a flat plate 1 mm thick; cutting a test piece 20 mm long and 6 mm wide from the flat plate; and measuring a refractive index of the test piece at the sodium D line at 20°C using a multi-wavelength Abbe refractometer (trade name "DR-M2" supplied by ATAGO Co., Ltd.) while keeping a prism and the test piece in intimate contact with each other using monobromonaphthalene as a contact liquid.

The viscosity of each of rubber-particle-dispersed epoxy compounds (A) prepared in the following production examples (each including 100 parts by weight of CELLOXIDE 2021P (supplied by Daicel Chemical Industries, Ltd.) and, dispersed therein, 5 parts by weight of rubber particles) was measured as a viscosity at 25°C using a digital viscometer (trade name "Model DVU-EII" supplied by Tokimec, Inc.).

PRODUCTION EXAMPLE 1

In a 1-liter polymerization reactor equipped with a reflux condenser were placed 500 g of ion-exchanged water and 0.68 g of sodium dioctylsulfosuccinate, followed by heating to 80°C with stirring in a nitrogen stream to give a mixture. The mixture was combined with a first monomer mixture added as a single unit, emulsified by stirring for 20 minutes, further combined with 9.5 mg of potassium peroxodisulfate, stirred for one hour to perform first seed polymerization, further combined with 180.5 mg of potassium peroxodisulfate, and stirred for 5 minutes to give a mixture. The mixture was further combined with a second monomer mixture added continuously over 2 hours to perform second seed polymerization, followed by ageing for one hour to yield a core. The first monomer mixture had been prepared by blending 9.5 g of butyl acrylate, 2.57 g of styrene, and 0.39 g of divinylbenzene, the amounts of which correspond to about 5 percent by weight of amounts necessary for the formation of the core. The second monomer mixture had been prepared by dissolving 0.95 g of sodium dioctylsulfosuccinate in 180.5 g of butyl acrylate, 48.89 g of styrene, and 7.33 g of divinylbenzene, the amounts of which correspond to the remainder (about 95 percent by weight) of the amounts necessary for the formation of the core.

Next, 60 mg of potassium peroxodisulfate was added to the core, stirred for 5 minutes, and a monomer mixture was continuously added thereto over 30 minutes to perform seed polymerization, aged for one hour, and thereby yielded a shell layer covering the core. The monomer mixture had been prepared by dissolving 0.3 g of sodium dioctylsulfosuccinate in 60 g of methyl methacrylate, 1.5 g of acrylic acid, and 0.3 g of allyl methacrylate.

Next, the resulting particle was cooled down to room temperature (25°C), filtrated through a plastic mesh with an opening of 120 μm, and yielded a latex including particles having a core-shell structure. The latex was frozen at minus 30°C, subjected to dewatering/washing using a suction filter, dried through air blowing at 60°C for a whole day, and yielded rubber particles (1). The resulting rubber particles (1) had an average particle diameter of 254 nm, a maximum particle diameter of 486 nm, and a refractive index of 1.500.

Using a dissolver heated to 60°C in a nitrogen stream (at 1000 rpm for 60 minutes), 5 parts by weight of the above-prepared rubber particles (1) were dispersed in 100 parts by weight of CELLOXIDE 2021P (3, 4-epoxycyclohexenylmethyl-3', 4'-epoxycyclohexene carboxylate, supplied by Daicel Chemical Industries Ltd.), degassed in vacuo, and yielded a rubber-particle-dispersed epoxy compound (A-1) having a viscosity at 25°C of 559 mPa·s.

PRODUCTION EXAMPLE 2

Rubber particles (2) were prepared by the procedure of Production Example 1, except for using 2.7 g of 2-hydroxyethyl methacrylate instead of 1.5 g of acrylic acid. The resulting rubber particles (2) had an average particle

diameter of 261 nm, a maximum particle diameter of 578 nm, and a refractive index of 1.500.
In addition, a rubber-particle-dispersed epoxy compound (A-2) having a viscosity at 25°C of 512 mPa·s was prepared by the procedure of Production Example 1, except for using the rubber particles (2).

PRODUCTION EXAMPLE 3

In a 1-liter polymerization reactor equipped with a reflux condenser were placed 500 g of ion-exchanged water and 1.3 g of sodium dioctylsulfosuccinate, followed by heating to 80°C with stirring in a nitrogen stream to give a mixture. The mixture was combined with a first monomer mixture added in a single unit, emulsified by stirring for 20 minutes, further combined with 12 mg of potassium peroxodisulfate, stirred for one hour to perform first seed polymerization, subsequently combined with 228 mg of potassium peroxodisulfate, and stirred for 5 minutes. This was combined with a second monomer mixture added continuously over 2 hours to perform second seed polymerization, aged for one hour, and yielded a core. The first monomer mixture had been prepared by blending 9.5 g of butyl acrylate, 2.57 g of styrene, and 0.39 g of divinylbenzene, the amounts of which correspond to about 5 percent by weight of amounts necessary for the formation of the core. The second monomer mixture had been prepared by dissolving 1.2 g of sodium dioctylsulfosuccinate in 180.5 g of butyl acrylate, 48.89 g of styrene, and 7.33 g of divinylbenzene, the amounts of which correspond to the remainder (about 95 percent by weight) of the amounts necessary for the formation of the core.
Next, rubber particles (3) were prepared by the procedure of Production Example 1, except for using acrylic acid in an amount of 2.0 g instead of 1.5 g. The resulting rubber particles (3) had an average particle diameter of 108 nm, a maximum particle diameter of 289 nm, and a refractive index of 1.500.
In addition, a rubber-particle-dispersed epoxy resin (A-3) having a viscosity at 25°C of 1036 mPa·s was prepared by the procedure of Production Example 1, except for using the rubber particles (3).

EXAMPLES 1 to 3 and COMPARATIVE EXAMPLES 1 to 5

Respective components in formulations (in part by weight) given in Table 1 were uniformly blended using a planetary stirring apparatus (trade name "AWATORIRENTARO (Thinky Mixer) AR-250" supplied by THINKY CORPORATION) at 2000 rpm for 5 minutes, degassed, and yielded curable epoxy resin compositions.
Next, each of the above-prepared curable epoxy resin compositions was cast into a die, heated, and yielded cured products. In each sample (Examples 1 to 3 and Comparative Examples 1 to 5), curing was performed by heating at 110°C for 3 hours (primary curing) and subsequently heating at 140°C for 4 hours (secondary curing).
Separately, each of the above-prepared curable epoxy resin compositions was cast into a lead frame of an optical semiconductor (AlInGaP element, 3.5 mm by 2.8 mm), heated at 110°C for 3 hours as primary curing, and subsequently heated at 140°C for 4 hours as secondary curing, and yielded optical semiconductor devices each including an optical semiconductor element sealed with a cured product derived from each curable epoxy resin composition, as illustrated in Figs. 1 to 4. In Figs. 1 to 4, reference signs 100 stands for a reflector (light-reflective resin composition), 101 stands for a metal line, 102 stands for a light-emitting diode, 103 stands for a bonding wire, 104 stands for a transparent sealing resin (cured product), and 105 stands for a package resin.

EXAMPLES 4 to 6 and COMPARATIVE EXAMPLES 6 to 10

Initially, a curing agent ("Rikacid MH-700" supplied by New Japan Chemical Co., Ltd.), a curing accelerator ("U-CAT 18X" supplied by San-Apro Ltd.), and an additive (ethylene glycol supplied by Wako Pure Chemical Industries, Ltd.) in formulations (in part by weight) given in Table 2 were uniformly mixed using a planetary stirrer (trade name "AWATORIRENTARO (Thinky Mixer) AR-250" supplied by THINKY CORPORATION), degassed, and yielded curing agent compositions.
Next, respective components in formulations (in part by weight) given in Table 2 were uniformly mixed using a planetary stirrer (trade name "AWATORIRENTARO (Thinky Mixer) AR-250" supplied by THINKY CORPORATION) at 2000 rpm for 5 minutes, degassed, and yielded curable epoxy resin compositions.
Subsequently, each of the above-prepared curable epoxy resin composition was cast into a die, heated, and yielded cured products. In each sample (Examples 4 to 6 and Comparative Examples 6 to 10), curing was performed by heating at 110°C for 3 hours (primary curing) and subsequently heating at 140°C for 4 hours (secondary curing).
Separately, each of the above-prepared curable epoxy resin compositions was cast into a lead frame of an optical semiconductor (AlInGaP element, 3.5 mm by 2.8 mm), heated at 110°C for 3 hours as primary curing, and subsequently heated at 140°C for 4 hours as secondary curing, and yielded optical semiconductor devices each including an optical semiconductor element sealed with a cured product derived from each curable epoxy resin composition, as illustrated in Figs. 1 to 4.
The curable epoxy resin compositions, cured products, and optical semiconductor devices prepared according

to the examples and comparative examples were evaluated by the following methods. The evaluation results are indicated in Tables 1 and 2.

[Difference in Refractive Index]

A refractive index of each of the cured products obtained in the examples and comparative examples were measured by cutting a test piece 20 mm long, 6 mm wide, and 1 mm thick from each cured product; and measuring a refractive index of the test piece at the sodium D line at 20°C using a multi-wavelength Abbe refractometer (trade name "DR-M2" supplied by ATAGO Co., Ltd.) while keeping a prism and the test piece in intimate contact with each other using monobromonaphthalene as a contact liquid. A difference in refractive index was then calculated according to the following expression:

Difference in refractive index = [Refractive index of rubber particles]-[Refractive index of cured product]

[Resin Leakage from Package]

In the optical semiconductor devices (twenty devices were prepared for each curable epoxy resin composition) obtained in the examples and comparative examples, portions between the reflector and the package substrate (portions "106" indicated in Fig. 4) were observed at a 100-fold measurement magnification using a digital microscope (trade name "VHX-900" supplied by Keyence Corporation). A sample, in which resin (cured product) leakage was observed in the portion(s) in at least one of the twenty optical semiconductor device specimens, was evaluated as with resin leakage "Present", and a sample, in which no resin (cured product) leakage was observed in any portion in any optical semiconductor device specimen, was evaluated as with resin leakage "Absent".

[Total Luminous Flux before Power-on (Zero Time)]

A total luminous flux (initial total luminous flux) before power-on (zero time) of each of the optical semiconductor devices obtained in the examples and comparative examples was measured using a total luminous flux measurement system (trade name "OL771 Multi-channel Spectroradiometric Measurement System" supplied by Optronic Laboratories, Inc.).

[High-temperature power-on Test]

A total luminous flux (zero hour; zero time) of each of the optical semiconductor devices obtained in the examples and comparative examples was measured using the total luminous flux measurement system. Next, a current of 100 mA was passed through each sample in a thermostat at 85°C for 3000 hours, and a total luminous flux of each sample was then measured using the total luminous flux measurement system. A luminosity retention (relative luminosity) of the sample was calculated according to the following expression: [Luminosity retention (relative luminosity) (%)] = [(Total luminous flux (lm) after power-on for 3000 hrs) /(Total luminous flux (lm) at zero hour)] × 100

[High-temperature and High-humidity power-on Test]

A total luminous flux (zero hour) of each of the optical semiconductor devices obtained in the examples and comparative examples was measured using the total luminous flux measurement system. Next, a current of 13 mA was passed through each sample in a thermostat at 60°C and 90% relative humidity for 3000 hours, and a total luminous flux of each sample was then measured using the total luminous flux measurement system. A luminosity retention (relative luminosity) was calculated according to the following expression:

[Luminosity retention (relative luminosity) (%)] = [(Total luminous flux (lm) after power-on for 3000 hrs)/(Total luminous flux (lm) at zero hour)] × 100

[Thermal Shock Test (Heat Shock Test)]

After checking that all the optical semiconductor devices obtained in the examples and comparative examples (twenty devices were prepared for each curable epoxy resin composition) had no crack, each of the devices was exposed to a test of repeating 2000 thermal cycles in a thermal shock chamber (trade name "TSE-11-A" supplied by ESPEC Corporation). In one thermal cycle, the sample was exposed to 100°C for 30 minutes and subsequently exposed to minus 40°C for 30 minutes.
Whether or not cracking occurred in the optical semiconductor devices was checked at 200-cycle intervals, and a number of cycles at the time when a first crack was observed to occur in any of the twenty optical semiconductor devices (number of cycles at which cracking first occurred) was recorded. Independently, a number of optical semiconductor devices, out of the twenty optical semiconductor devices, which suffered from cracking (number of packages which suffered from cracking) after 2000 cycles was recorded. The presence or absence of cracking was determined in observation with a digital microscope (trade name "VHX-900" supplied by Keyence Corporation).
[Table 1]

TABLE 1

| | | | Ex.1 | Ex.2 | Ex.3 | Com. Ex.1 | Com. Ex. 2 | Com. Ex. 3 | Com. Ex. 4 | Com. Ex. 5 |
|---|---|---|---|---|---|---|---|---|---|---|
| Curable epoxy resin composition | Rubber-particle-dispersed epoxy compound (A-1) [part by weight] | | 60 | 70 | 80 | 80 | 70 | 60 | 60 | 60 |
| | Alumina (B) | AO802 [part by weight] | 0.2 | 0.2 | 0.2 | - | - | 0.2 | - | - |
| | Aliphatic polyglycidyl ether (C) | ERISYS GE60 [part by weight] | 10 | 10 | 10 | - | - | - | 10 | - |
| | Curing catalyst (F) | San-Aid SI-150L [part by weight] | 1 | 1 | 1 | 1 | 1 | 1 | 1 | 1 |
| | Bisphenol-A epoxy compound | YD8125 [part by weight] | 20 | 10 | - | - | 20 | 20 | 20 | 20 |
| | Glycidyl ether epoxy compound | YX8034 [part by weight] | 10 | - | 10 | 10 | 10 | 10 | 10 | 10 |
| | having no aromatic ring | YH300 [part by weight] | - | 10 | - | 10 | - | 10 | - | 10 |
| Cured product | Difference in refractive index | | 0.03 | 0.03 | 0.03 | 0.01 | 0.01 | 0.03 | 0.01 | 0.02 |
| Optical semiconductor device | Total luminous flux [lm] before power-on (0 hr) | | 1.02 | 1.01 | 1.02 | 1.03 | 0.99 | 1.06 | 1.01 | 1.02 |
| | Relative luminosity after high-temperature power-on test (3000 hrs) | | 89% | 81% | 80% | 79% | 82% | 92% | 67% | 81% |
| | Relative luminosity after high-temperature and high-humidity power-on test (3000 hrs) | | 109% | 95% | 97% | 95% | 90% | 103% | 98% | 90% |
| | Thermal shock test (2000 cycles) | Number of packages suffering from cracking [per 20 samples] | 0 | 0 | 0 | 0 | 6 | 1 | 1 | 10 |
| | | Number of cycles at which cracking first occurred [cycle] | - | - | - | - | 600 | 1600 | 800 | 600 |
| | Resin leakage from package | | Absent | Absent | Absent | Present | Present | Absent | Present | Present |

[Table 2]

(TABLE 2)

| | | | | Ex. 4 | Ex. 5 | Ex.6 | Com. Ex. 6 | Com. Ex. 7 | Com. Ex. 8 | Com. Ex. 9 | Com. Ex. 10 |
|---|---|---|---|---|---|---|---|---|---|---|---|
| Curable epoxy resin composition | Rubber-particle-dispersed epoxy compound (A-1) [part by weight] | | | 60 | 70 | 80 | 80 | 70 | 60 | 60 | 60 |
| | Alumina (B) | | AO802 [part by weight] | 0.2 | 0.2 | 0.2 | - | - | 0.2 | - | - |
| | Aliphatic polyglycidyl ether (C) | | ERISYS GE60 [part by weight] | 10 | 10 | 10 | - | - | - | 10 | - |
| | Bisphenol-A epoxy compound | | YD8125 [part by weight] | 20 | 10 | - | - | 20 | 20 | 20 | 20 |
| | Glycidyl ether epoxy compound having no aromatic ring | | YX8034 [part by weight] | 10 | - | 10 | 10 | 10 | 10 | 10 | 10 |
| | | | YH300 [part by weight] | - | 10 | - | 10 | - | 10 | - | 10 |
| | Curing agent composition | Curing agent (D) | Rikacid MH-700 [part by weight] | 115 | 130 | 120 | 115 | 110 | 110 | 115 | 110 |
| | | Curing accelerator (E) | U-CAT 18X [part by weight] | 0.5 | 0.5 | 0.5 | 0.5 | 0.5 | 0.5 | 0.5 | 0.5 |
| | | Addictive | Ethylene glycol [part by weight] | 1 | 1 | 1 | 1 | 1 | 1 | 1 | 1 |
| Cured product | Difference in refractive index | | | 0.03 | 0.03 | 0.03 | 0.01 | 0.01 | 0.03 | 0.01 | 0.02 |

(continued)

| | | | Ex. 4 | Ex. 5 | Ex.6 | Com. Ex. 6 | Com. Ex. 7 | Com. Ex. 8 | Com. Ex. 9 | Com. Ex. 10 |
|---|---|---|---|---|---|---|---|---|---|---|
| Optical semiconductor device | Total luminous flux [lm] before power-on (0 hr) | | 1.00 | 1.01 | 1.01 | 1.02 | 0.99 | 1.05 | 1.02 | 1.03 |
| | Relative luminosity after high-temperature power-on test (3000 hrs) | | 88% | 83% | 82% | 78% | 81% | 91% | 75% | 79% |
| | Relative luminosity after high-temperature and high-humidity power-on test (3000 hrs) | | 100% | 93% | 95% | 93% | 91% | 99% | 90% | 91% |
| | Thermal shock test (2000 cycles) | Number of packages suffering from cracking [per 20 samples] | 0 | 0 | 0 | 0 | 4 | 5 | 5 | 11 |
| | | Number of cycles at which cracking first occurred [cycle] | - | - | - | - | 800 | 1200 | 1000 | 1000 |
| | Resin leakage from package | | Absent | Absent | Absent | Present | Present | Absent | Present | Present |

Abbreviations in Tables 1 and 2 indicate as follows:

"YD8125": Bisphenol-A epoxy resin, supplied by Tohto Kasei Co., Ltd.
"YX8034": Hydrogenated bisphenol-A epoxy resin, supplied by Mitsubishi Chemical Corporation
"YH300": Trimethylolpropane triglycidyl ether (viscosity (25°C): 140 mPa·s), supplied by Tohto Kasei Co., Ltd.
"AO802": Alumina (average particle size: 0.7 μm, shape: spherical, preparation process: VMC process), supplied by Admatechs Company Limited
"ERISYS GE60": Sorbitol polyglycidyl ether (viscosity (25°C) : 13000 mPa·s), supplied by CVC Thermoset Specialties
"San-Aid SI-150L": Arylsulfonium salt, supplied by Sanshin Chemical Industry Co., Ltd.
"Rikacid MH-700": 70:30 Mixture of 4-methylhexahydrophthalic anhydride and hexahydrophthalic anhydride, supplied by New Japan Chemical Co., Ltd.
"U-CAT 18X": Curing accelerator, supplied by San-Apro Ltd.
"Ethylene glycol": Product of Wako Pure Chemical Industries, Ltd.

As is demonstrated by Tables 1 and 2, optical semiconductor devices using curable epoxy resin compositions according to the present invention gave cured products which had thermal stability, lightfastness, and transparency at high levels, exhibited a high level of cracking resistance, and did not suffer from resin leakage from the package. In contrast, samples (comparative examples) not containing either one or both of the alumina (B) and the aliphatic polyglycidyl ether (C) failed in the thermal shock test and/or in the determination of the presence or absence of resin leakage from the package.
Samples employing the rubber-particle-dispersed epoxy compound (A-2) or the rubber-particle-dispersed epoxy compound (A-3) instead of the rubber-particle-dispersed epoxy compound (A-1) had similar results as above. Reference Signs List
100: reflector (light-reflective resin composition)
101: metal line
102: light-emitting diode
103: bonding wire
104: transparent sealing resin (cured product)
105: package resin
106: gap between metal line and reflector (portion in which the presence or absence of resin leakage is determined)

Industrial Applicability

Curable epoxy resin compositions according to the present invention are advantageously usable in various fields including sealants for electrics/electronics related to optical semiconductors. The curable epoxy resin compositions, particularly when used as sealants for optical semiconductors, give optical semiconductor devices which can keep on exhibiting high performance over a long time and serve as long-life optical semiconductor devices with high reliability.

## Claims

1. A curable epoxy resin composition comprising a rubber-particle-dispersed epoxy compound (A) including an alicyclic epoxy compound and, dispersed therein, rubber particles;
wherein the curable epoxy resin composition further comprises an alumina (B); and an aliphatic polyglycidyl ether (C) having a viscosity of 8000 mPa·s or more at 25°C;
wherein the rubber particles include a polymer derived from a (meth)acrylic ester as an essential monomer component, have hydroxyl group and/or carboxyl group on a surface thereof, and have an average particle diameter of 10 nm to 500 nm and a maximum particle diameter of 50 nm to 1000 nm; and
wherein the curable epoxy resin composition gives a cured product having a refractive index with a difference from a refractive index of the rubber particles of within ±0.03.

2. The curable epoxy resin composition of claim 1, further comprising a curing agent (D) and a curing accelerator (E), or further comprising a curing catalyst (F).

3. The curable epoxy resin composition of claim 2, wherein the curing agent (D) is an acid anhydride that is liquid at 25°C.

**4.** The curable epoxy resin composition of claim 2, wherein the curing catalyst (F) is a cationic-polymerization initiator that generates a cationic species through application of an ultraviolet ray or heat.

**5.** The curable epoxy resin composition of any one of claims 1 to 4, further comprising a glycidyl ether epoxy compound having no aromatic ring (other than the aliphatic polyglycidyl ether (C)) and/or a polyol compound present as a liquid at 25°C (other than a polyether polyol and the aliphatic polyglycidyl ether (C)).

**6.** The curable epoxy resin composition of any one of claims 1 to 5, wherein the aliphatic polyglycidyl ether (C) is a sorbitol polyglycidyl ether.

**7.** The curable epoxy resin composition of any one of claims 1 to 6, for sealing of an optical semiconductor.

**8.** An optical semiconductor device comprising an optical semiconductor element sealed with the curable epoxy resin composition of claim 7.

[Fig. 1]

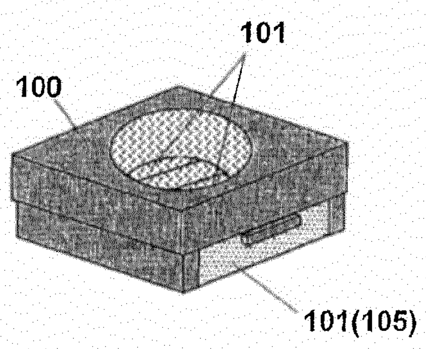


[Fig. 2]

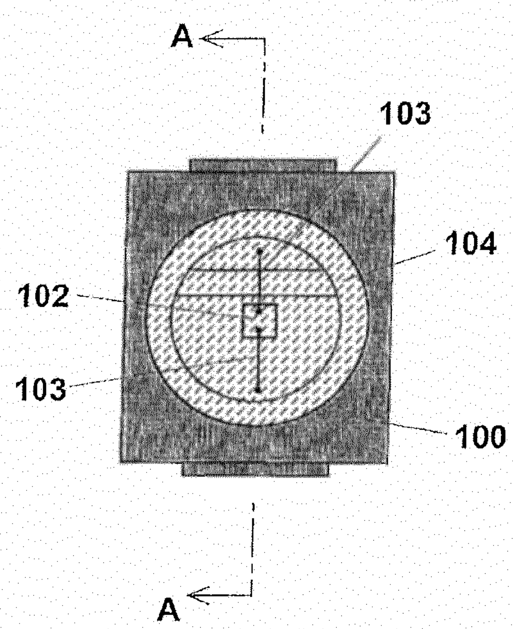

[Fig. 3]

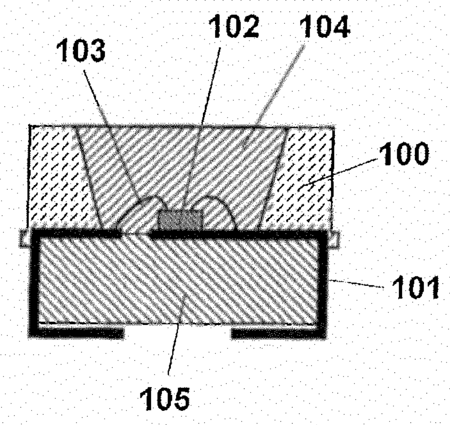


[Fig. 4]

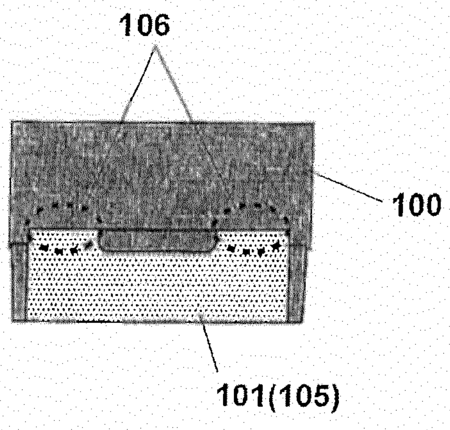

**INTERNATIONAL SEARCH REPORT**

International application No.
PCT/JP2011/078768

A. CLASSIFICATION OF SUBJECT MATTER
*C08L63/00*(2006.01)i, *C08G59/20*(2006.01)i, *H01L23/28*(2006.01)i

According to International Patent Classification (IPC) or to both national classification and IPC

B. FIELDS SEARCHED

Minimum documentation searched (classification system followed by classification symbols)
C08L63/00-63/10, C08G59/20-59/38, H01L23/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2010/013407 A1 (Daicel Chemical Industries, Ltd.), 04 February 2010 (04.02.2010), claims; examples & EP 2308909 A1 & CN 102046690 A & KR 10-2011-0041497 A | 1-8 |
| A | WO 2006/019041 A1 (Kaneka Corp.), 23 February 2006 (23.02.2006), claims; paragraphs [0026], [0030] to [0033], [0039], [0040], [0058], [0059] & US 2007/0251419 A1 & EP 1780239 A1 | 1-8 |
| A | JP 2007-238744 A (KYOCERA Chemical Corp.), 20 September 2007 (20.09.2007), claims; paragraph [0014] (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 March, 2012 (09.03.12) | 19 March, 2012 (19.03.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/078768

C (Continuation). DOCUMENTS CONSIDERED TO BE RELEVANT

| Category* | Citation of document, with indication, where appropriate, of the relevant passages | Relevant to claim No. |
|---|---|---|
| A | JP 10-36637 A (Dainippon Ink and Chemicals, Inc.), 10 February 1998 (10.02.1998), claims; paragraphs [0032], [0038] (Family: none) | 1-8 |
| A | JP 1-109753 A (Hitachi, Ltd.), 26 April 1989 (26.04.1989), claims; page 21, upper right column, lines 6 to 20 (Family: none) | 1-8 |
| A | JP 4-325543 A (Shin-Etsu Chemical Co., Ltd.), 13 November 1992 (13.11.1992), claims; paragraph [0018] (Family: none) | 1-8 |
| A | JP 2007-191519 A (Taiyo Ink Manufacturing Co., Ltd.), 02 August 2007 (02.08.2007), claims; paragraph [0009] (Family: none) | 1-8 |
| A | JP 9-87363 A (Nippon Zeon Co., Ltd.), 31 March 1997 (31.03.1997), claims; paragraph [0013] (Family: none) | 1-8 |
| A | JP 2009-227849 A (Sanyo Chemical Industries, Ltd.), 08 October 2009 (08.10.2009), claims; paragraph [0017] (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H09255764 A
- JP 2005255822 A
- JP H11240939 A
- WO 2010013407 A
- JP 2008174624 A